# EUROPEAN PATENT APPLICATION

(11) **EP 1 701 599 A1**
(43) Date of publication of application: **13.09.2006**
(21) Application number: 05005273.7
(22) Date of filing: 10.03.2005
(51) Int. Cl.: H05K 1/18

(54) **Circuit board for hiding electronic components**

(71) Applicant: Optium Care International Tech. Inc., 114 Taipei City (TW)
(72) Inventor: Lien, Jeffrey, Shihlin District Taipei City 111 Taiwan (TW)
(74) Representative: Vossius & Partner

(57) **Abstract**

The present invention is related to an assembly structure for hiding electronic components, that is, at least one containing hole penetrating through a PCB being set on a predetermined location of the PCB, circuits being arranged on at least one surface of a predetermined side edge of the containing hole, the containing hole being capable of reserving at least one electronic component (IC chip, resistance, capacitance or LED, etc.) so as to that at least one leg of the electronic component extending and connecting to the circuits of the surface for welding, the assembly structure for hiding electronic components is therefore formed.

## Description

### FIELD OF THE INVENTION

The present invention relates to an assembly structure for hiding electronic components, especially to the assembly structure of electronic components and PCBs being broadly applied to motherboard, displaying card, sound card, network card or other PCBs with additional functions.

### BACKGROUND OF THE INVENTION

There are some electronic circuits on a PCB, and some specific electronic components are welded on the PCB for special functions, hence this is the assembly for traditional PCBs and electronic components (IC chip, resistance, capacitance or LED, etc.), such as PCBs for motherboard, displaying card, memory card, network card, mobile phone and other PCBs with additional functions. The present electronic products tending to be small volumes, lightweights and multiple functions is an important issue, therefore how to integrally and effectively utilize PCB space to layout more or multiple electronic components becomes a challenge for IC designer.

Additionally the prior PCBs have a plurality of types of welded electronic components thereon and cannot suitably hide some electronic components with specific technologies. Competitors are able to recognize those electronic components with specific technologies from layout surfaces of the PCBs very easily, and improper ways to gain confidential technologies and imitation may then be derived. As it can be seen, the exposed assembly structures for the electronic components and PCBs are not able to fully employ their spaces thereon and protect specific technologies.

### SUMMARY OF THE INVENTION

The primary objective of the present invention is to provide an assembly structure for hiding electronic components, especially the structure is broadly applied to the multiple types of PCBs and electronic components for effectively employing the PCBs' spaces to reduce volumes and hiding the electronic components with specific technologies.

According to above objective, the present invention adopts that setting at least one containing hole structure with ladder or opening shape penetrating through a PCB or sunken shape, and laying out electronic circuits aside of the containing hole, then at least one electronic component is contained in the containing hole, and two legs of the electronic component are able to extend to a surface of the PCB for welding. The assembly structure may then hide electronic components to further save the PCBs' spaces; more, while other components are arranged above the containing hole, a purpose to disguise those components with specific technologies is achieved.

### BRIEF DESCRIPTION OF THE DRAWINGS

Fig. 1 is a 3-D sketch of the present invention applied on a PCB;
Fig. 2 is a sectional view of the present invention applied on a PCB;
Fig. 3 is a sketch of plural electronic components arranged side by side of containing holes of the present invention;
Fig. 4 is a sketch of plural electronic components stacked up in containing holes of the present invention;
Fig. 5 is a sketch of a preferred embodiment of a welding point with through hole of the present invention;
Fig. 6 is a sketch of a preferred embodiment of a welding point without through hole of the present invention;
Fig. 7 is a sketch of a PCB with a hollow containing hole of the present invention;
Fig. 8 is a sketch of double surfaces with hollow containing holes of a PCB of the present invention;
Fig. 9 is a sketch of a preferred embodiment of a penetrating containing hole with ladder shape;
Fig. 10 is a sketch of a preferred embodiment of a hollow containing hole with ladder shape.

### DETAILED DESCRIPTION OF THE PREFERRED EMBODIMENTS

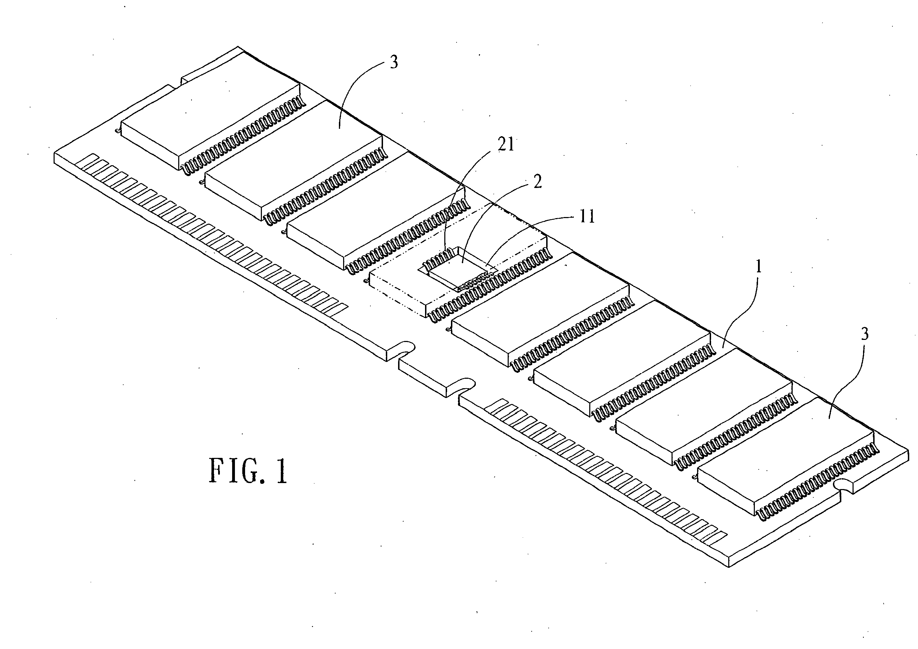

Please refer to Fig. 1. The present invention is to design an assembly structure for hiding electronic components; the assembly structure can be broadly applied onto a plurality of types of PCBs of motherboard, displaying card, memory card, network card, mobile phone and others with specific technologies. The embodiment is as following:

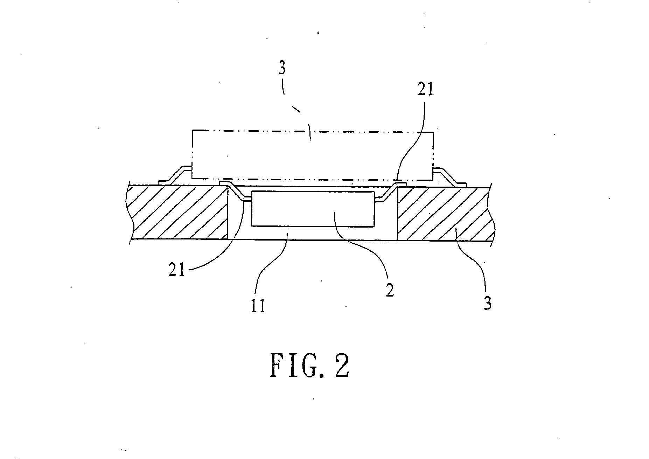

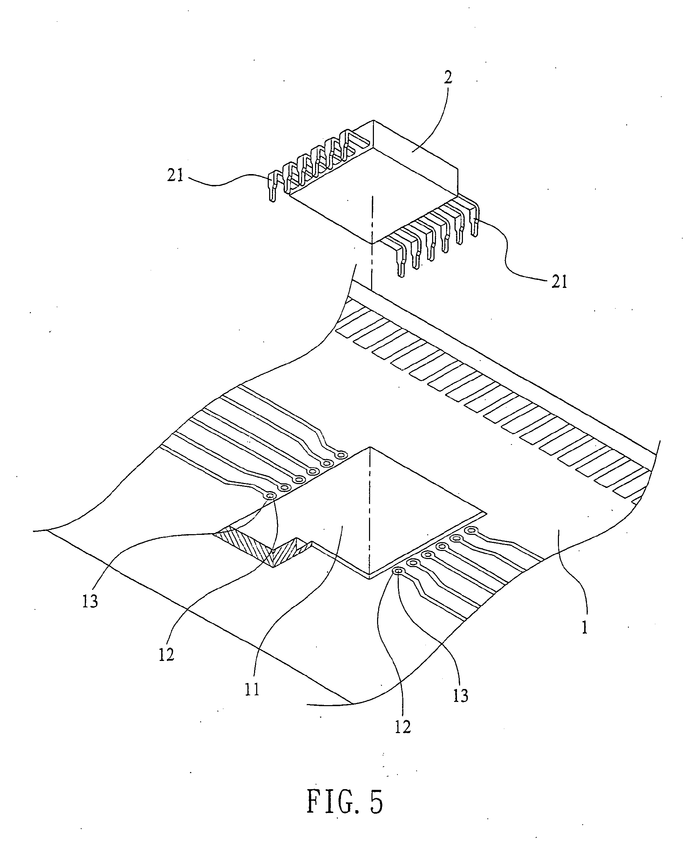

According to specific functions of circuits as aforesaid motherboard, memory card, etc. or space need, to set and penetrate at least one containing hole 11 (refer to Fig. 2) on a certain position of a PCB 1, and the containing hole 11 is shaped as a rectangular or other needed figures, a plurality of welding points 12 (refer to Fig. 5) of circuits (probably printed circuits) are made on a side or a side edge of the containing hole 11; the containing hole 11 has at least one electronic component 2 for containing to let legs 21 of the electronic component 2 (IC chip, resistance, capacitance or LED, etc.) elongate to a surface of the PCB 1 for welding so as to construct the assembly structure of the present invention; due to the leg 21 being suitably folded (a plurality of legs of two sides of IC chip), the only necessary procedure to weld the assembly structure mentioned above is to reversely insert the electronic component into the containing hole 11 of the PCB 1 to assemble the structure of the present invention.

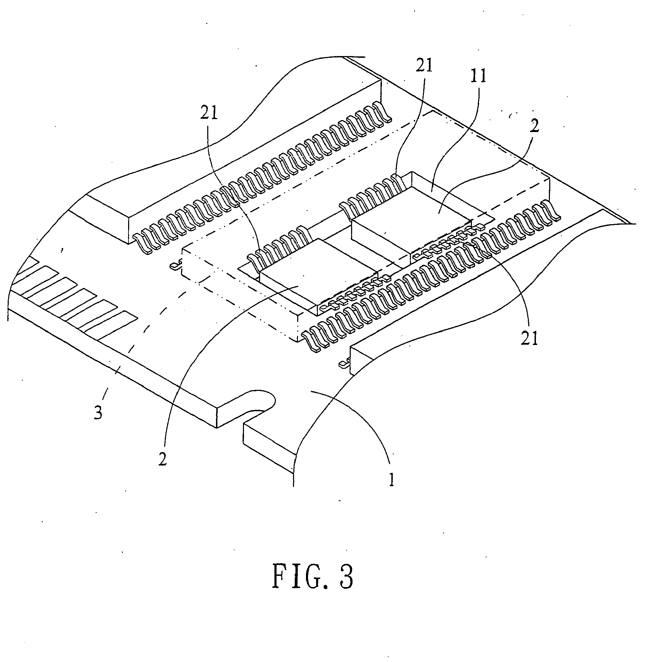

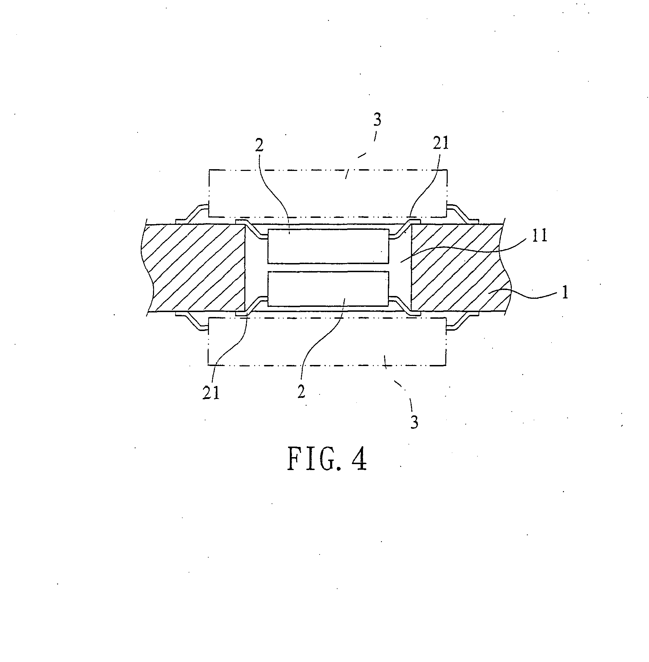

Please refer to Fig. 3. The containing hole 11 is able to reserve at least one electronic component 2, and the embodiments comprise: a structure for welding at least two electronic components 2 arranged side by side in the containing hole 11; having circuits on two surfaces of predetermined side edges around the containing holes 11 for two electronic components stacked up in the containing hole 11 (shown as Fig. 4) and extending the legs 21 to the two surfaces for welding, hence it is to approach the purpose of fully employing the PCB spaces.

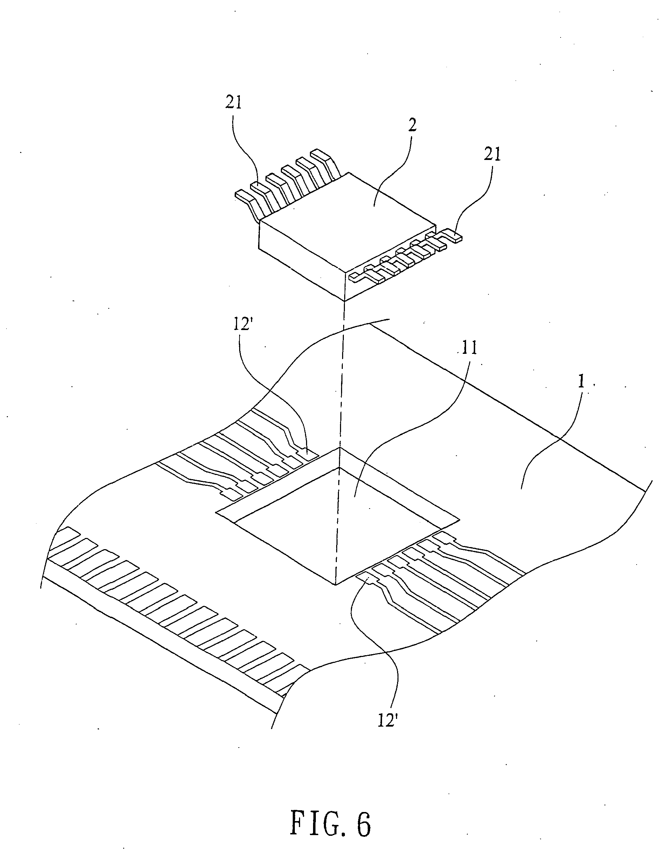

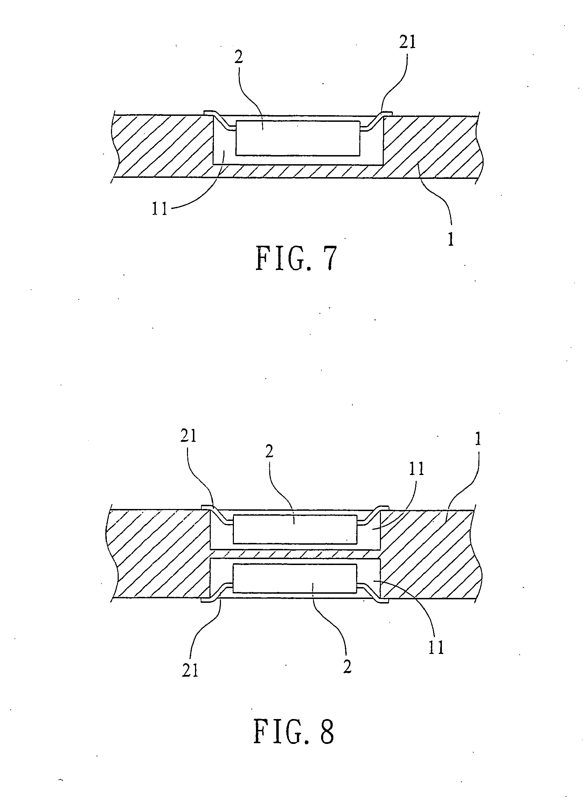

Please refer to Fig. 5. The welding points 12 can be further added through holes 13 so as to that the electronic components 12 being sunken into the containing holes 11 and the legs 21 being planted into the through holes 13 to connect to the welding points 12 for welding; on the other hand, as shown in Fig. 6, the welding points 12' are defined as connecting points between circuits of PCBs and themselves, that is, the embodiment is without through holes 13, however, the embodiment provides that the electronic components 2 are sunken into the containing hole 11 as well, and the legs 21 and the welding points 12' are connected each other on the surface. Referring to Fig. 7, the scope of the structure of the containing hole 11 is not limited by the PCB 1 with through holes; the containing hole 11 can be a sunken figure arranged on a surface of the PCB 1 or two surfaces of the PCB 1 with different positions, shown as in Fig. 8, therefore the structure to provide the electronic component 2 sunken for assembling is complete.

Due to the electronic components 2 being sunken into the PCB 1, other electronic components with big volumes as processor chip, memory chip, connector, etc. can be covered on the containing holes 11 for inserting or welding connection, shown as in Figs. 2 and 3. It is to not only save the space, but also hiding the specific means for the electronic components 2 to avoid imitation.

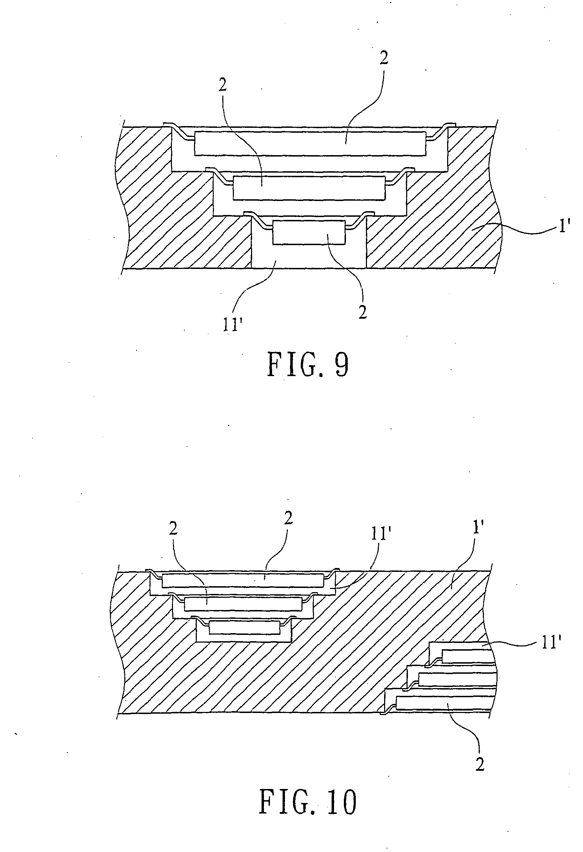

Referring to Fig. 9, the containing hole 11 can be as a vertical penetrating through hole or a hollow hole on the PCB 1 for sinking the electronic component 2, and further that a ladder shape of the through containing hole 11' is applied to the multi-layer PCB 1', or a ladder shape of the sunken containing hole 11' being as well, shown as in Fig. 10. By means of the embodiment, the plurality of tiny electronic components 2 are sunken and assembled in each layer of the containing hole 11' individually and electrically connected to circuits of each layer so as to save spaces and keep confidential information.

Based on the preferred embodiments mentioned, the tendency of the current PCB may be smaller in volume to match with the present electrical products with small volumes and lightweights. As a conclusion, to employ spaces under the bigger elements 3 to have the containing hole 11 are able to hide other smaller electronic components 2 for welding, therefore the exposed configurations of mounting electronic components on a PCB side by side in prior arts can be avoided. Obviously, it is known that the present invention further employs the PCB spaces and narrows the PCB volumes to conceal the confidential theory of the technologies for preventing imitation.

While the invention has been described by way of example and in terms of a preferred embodiment, it is to be understood that the invention is not limited thereto. To the contrary, it is intended to cover various modifications and similar arrangements and procedures, and the scope of the appended claims therefore should be accorded the broadest interpretation so as to encompass all such modifications and similar arrangements and procedures.

## Claims

1. An assembly structure for hiding electronic components characterized:
at least one containing hole penetrating through a PCB being set on a predetermined location of the PCB, a plurality of circuits being arranged on at least one surface of a predetermined side edge of the containing hole, the containing hole being capable of reserving at least one electronic component so as to that at least one leg of the electronic component extending and connecting to the circuits of the surface for welding;
the assembly structure for hiding electronic components is therefore formed.

2. The assembly structure for hiding electronic components as cited in claim 1, wherein the containing hole can reserve at least one electronic component and be shaped as hollow to be located on any of the following: one surface of the PCB, two surfaces of the PCB.

3. The assembly structure for hiding electronic components as cited in claim 1, wherein the containing hole has ladder shape for assembling electronic components on each layer.

4. The assembly structure for hiding electronic components as cited in claim 2, wherein the containing hole has ladder shape for assembling electronic components on each layer.

5. The assembly structure for hiding electronic components as cited in claim 1, wherein at least one electronic component can be installed in the containing hole side by side for welding.

6. The assembly structure for hiding electronic components as cited in claim 2, wherein at least one electronic component can be installed in the containing hole side by side for welding.

7. The assembly structure for hiding electronic components as cited in claim 1, wherein at least two electronic components can be stacked up in the containing hole, and at lease one leg of each electronic component extends to any surface of the PCB for welding.

8. The assembly structure for hiding electronic components as cited in claim 2, wherein at least two electronic components can be stacked up in the containing hole, and at lease one leg of each electronic component extends to any surface of the PCB for welding.

9. The assembly structure for hiding electronic components as cited in claim 1, wherein above the containing hole is capable of installing other electronic components, the components are engaged in any type of following connections with the PCB: inserting connection and welding connection.

10. The assembly structure for hiding electronic components as cited in claim 2, wherein above the containing hole is capable of installing other electronic components, the components are engaged in any type of following connections with the PCB: inserting connection and welding connection.

11. The assembly structure for hiding electronic components as cited in claim 1, wherein a plurality of welding points are defined as circuits on the surface of the predetermined side edge of the containing hole, each welding point is shaped as following types to connect to the leg of the electronic component: a welding point with through hole, a welding point without through hole.

12. The assembly structure for hiding electronic components as cited in claim 2, wherein a plurality of welding points are defined as circuits on the surface of the predetermined side edge of the containing hole, each welding point is shaped as following types to connect to the leg of the electronic component: a welding point with through hole, a welding point without through hole.

13. The assembly structure for hiding electronic components as cited in claim 1, wherein the assembly structure of the PCB and the electronic components can be one of the following: motherboard, displaying card, memory card, network card, mobile phone and others with specific technologies.

14. The assembly structure for hiding electronic components as cited in claim 2, wherein the assembly structure of the PCB and the electronic components can be one of the following: motherboard, displaying card, memory card, network card, mobile phone and others with specific technologies.
